(19) Europäisches Patentamt

European Patent Office

Office européen des brevets

(11) Veröffentlichungsnummer: **0 361 035**
**A2**

(12) **EUROPÄISCHE PATENTANMELDUNG**

(21) Anmeldenummer: 89114582.3

(22) Anmeldetag: 07.08.89

(51) Int. Cl.5: **H01S 3/25 , H01S 3/103 , G02F 3/02**

(30) Priorität: 27.09.88 DE 3832760

(43) Veröffentlichungstag der Anmeldung:
04.04.90 Patentblatt 90/14

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Amann, Markus-Christian, Dr.**
**Unterhachinger Strasse 89**
**D-8000 München 83(DE)**
Erfinder: **Stegmüller, Bernhard, Dr.**
**Seefelder Strasse 18**
**D-8900 Augsburg(DE)**

(54) **Halbleiterlaseranordnung und Verfahren zu ihrem Betrieb.**

(57) Es soll eine Halbleiterlaseranordnung aus hintereinander oder parallel zueinander geschalteten Halbleiterlasern angegeben werden, mit der ein beliebiger Grad von Isotropie oder Anisotropie des optischen Verstärkungsfaktors einstellbar ist.

Die beiden Halbleiterlaser bestehen aus quasi-indexgeführten Laserdioden (LD1, LD2), von denen jede eine in einer beiden Dioden (LD1, LD2) gemeinsamen Schichtebene (E) angeordnete lichtverstärkende Schicht (Sch1, Sch2) aufweist. Durch das Verhältnis ($I_1/I_2$) der Betriebsströme ($I_1$,$I_2$) der Dioden (LD1, LD2) läßt sich jedes gewünschte Maß der Polarisationsabhängigkeit der Verstärkung einstellen. Insbesondere kann isotrope Verstärkung erzielt werden.

Laser für den Weitverkehr

FIG 1

## Halbleiterlaseranordnung und Verfahren zu ihrem Betrieb

Die Erfindung betrifft eine Halbleiterlaseranordnung nach dem Oberbegriff des Patentanspruchs 1.

Für Anwendungen in der optischen Nachrichtentechnik werden in modernen Systeme optische Verstärker oder Laserverstärker benötigt, die polarisiertes Licht isotrop verstärken können. Isotrop verstärken bedeutet dabei, daß Licht beliebiger Polarisation unabhängig von dieser Polarisation mit dem gleichen Verstärkungsgrad verstärkt werden kann. Bei einem Halbleiterlaser mit lichtverstärkend wirkender Schicht ist die optische Verstärkung in der Regel stark polarisationsabhängig, beispielsweise derart, daß in der Ebene der Schicht polarisiertes Licht relativ stark und senkrecht zu dieser Ebene polarisiertes Licht realtiv schwach oder nicht verstärkt wird. Eine isotrope Verstärkung kann dadurch erreicht werden, daß das zu verstärkende polarisierte Licht in zwei in Reihe oder parallel zueinander angeordnete Halbleiterlaser eingekoppelt wird, deren lichtverstärkend wirkende Schichten in vertikal zueinander angeordneten Ebenen liegen und die den gleichen Verstärkungsfaktor aufweisen. Eine derartige Anordnung ist aus ECOC, 1987, S. 87 bis 88 bekannt. Bei dieser Anordnung liegt beispielsweise die lichtverstärkend wirkende Schicht eines Halbleiterlasers in der Schwingungsebene des TE-Modus, während die entsprechende Schicht des anderen Halbleiterverstärkers in der Schwingungsebene des TM-Modus liegt, der orthogonal zum TE-Modus polarisiert ist. Beide Halbleiterlaser der bekannten Anordnung können durch passive optische Wellenleiter miteinander verbunden sein, die polarisationserhaltend sind. Auch eine Zufuhr des zu verstärkenden polarisierten Lichts und das Fortleiten des verstärkten Lichts kann durch solche Wellenleiter erfolgen.

Aufgabe der Erfindung ist es, eine Anordnung der eingangs genannten Art anzugeben, mit der ein beliebiger Grad von Iso tropie oder Anisotropie des optischen Verstärkungsfaktors einstellbar ist.

Diese Aufgabe wird durch die im kennzeichnenden Teil des Patentanspruchs 1 angegebenen Merkmale gelöst.

Die erfindungsgemäße Anordnung löst das Problem des isotropen optischen Verstärkens durch Ausnutzung einer strukturspezifischen Eigenschaft der quasi-indexgeführten Laserdioden, die beispielsweise aus Journ. of Lightwave Techn., Vol. LT-2, No. 4, Aug. 1984 bekannt sind. Dabei läßt sich jeder gewünschte Grad von isotroper und anisotroper optischer Verstärkung durch geeignete Wahl der geometrischen Strukturdaten, insbesondere der Breite des bei derartigen Dioden vorhandenen Streifenwellenleiters (siehe dazu Appl. Phys.

Lett. 50 (16), 20. April 1987, S. 1038-1040) einstellen. Bei der erfindungsgemäßen Anordnung sind die geometrischen Strukturdaten der beiden quasi indexgeführten Laserdioden so gewählt, daß eine Diode den einen Polarisationszustand und die andere den anderen Polarisationszustand bevorzugt verstärkt. Durch Wahl der Betriebsströme, die diesen Dioden zuzuführen sind, läßt sich dann jedes gewünschte Maß der Polarisationsabhängigkeit der Verstärkung einstellen. Insbesondere kann für beide Polarisationszustände gleiche Verstärkung, d.h. isotrope Verstärkung, erzielt werden.

Bei einer vorteilhaften Ausgestaltung der erfindungsgemäßen Anordnung sind die beiden quasi indexgeführten Laserdioden monolithisch integriert.

Bei der Anwendung der erfindungsgemäßen Anordnung als Verstärker, bei dem jedes gewünschte Maß an Polarisationsabhängigkeit der Verstärkung einstellbar ist, ist es zweckmäßig, wenn gemäß Anspruch 4 brechende Ein- und Austrittsflächen für optische Wellen entspiegelt sind.

Bei einer anderen bevorzugten Ausgestaltung der erfindungsgemäßen Anordnung sind gemäß Anspruch 5 brechende Ein- und Aus trittsflächen für optische Wellen reflektierend. Mit dieser Ausgestaltung kann ein frequenzselektiver Fabry-Perot-Verstärker oder ein polarisations-bistabiles Sendeelement realisiert werden, das sehr schnell modulierbar ist.

Ein Verfahren zum Betrieb einer erfindungsgemäßen Anordnung, insbesondere der Anordnung nach Anspruch 5 zur Realisierung einer in Bezug auf zwei verschiedene Polarisationszustände bistabilen Sendeanordnung geht aus dem Anspruch 6 hervor.

Die Erfindung wird anhand der Figuren in der folgenden Beschreibung beispielhaft näher erläutert. Von den Figuren zeigen:

Figur 1 eine Anordnung aus zwei in Reihe hintereinander geschalteten, monolithisch integrierten, quasi-indexgeführten Laserdioden,

Figur 2 einen Längsschnitt durch die Anordnung nach Figur 1 längs der Schnittlinie II - II,

Figur 3 graphisch die Gesamtverstärkung der Anordnung nach Figur 1 in Abhängigkeit von dem Verhältnis der an die beiden Dioden angelegten Betriebsströme $I_1$ und $I_2$ und

Figur 4 eine graphische Darstellung, welche die von einer als polarisations-bistabiles Sendeelement betriebenen Anordnung nach Figur 1 und 2 abgegebene Lichtleistung und darunter die angelegten Betriebsströme $I_1$ und $I_2$ jeweils über der Zeit t aufgetragen sind.

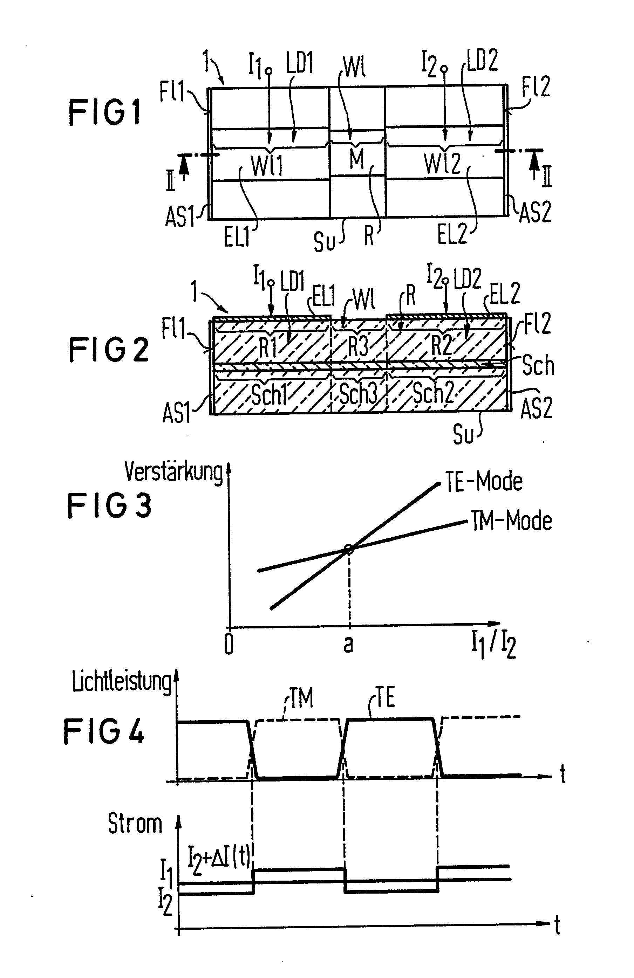

Bei dem Ausführungsbeispiel nach den Figuren 1 und 2 ist auf einem Substrat Su in bekannter Weise ein Streifenwellenleiter W1 in Form eines Rippenwellenleiters definiert (siehe dazu Appl. Phys. Lett 50 (16), 20. April 1987, S. 1038, insbesondere Figur 1). Dieser Streifenwellenleiter besteht im wesentlichen aus einer im Inneren des Substrats Su in einer Schichtebene E angeordneten wellenleitenden, lichtverstärkend wirkenden Schicht Sch und aus einer über der Schicht Sch angeordneten Rippe R an der Oberfläche des Substrats. Auf einem linken Endabschnitt der Rippe R ist eine Elektrode EL1 und auf einem rechten Endabschnitt eine Elektrode EL2 aufgebracht.

Die Elektrode EL1 definiert zusammen mit dem darunter befindlichen linken Endabschnitt W11 des Streifenwellenleiters W1, bestehend aus dem linken Endabschnitt R1 der Rippe R und dem darunter befindlichen linken Endabschnitt Sch1 der Schicht Sch, eine quasi-indexgeführte Laserdiode LD1, während die andere Elektrode EL2 zusammen mit dem darunter befindlichen rechten Endabschnitt W12 des Streifenwellenleiters W1, bestehend aus dem rechten Endabschnitt R2 der Rippe R und dem darunter befindlichen Endabschnitt Sch2 der Schicht Sch, eine andere quasi-indexgeführte Laserdiode LD2 definiert. Ein zwischen den im Abstand voneinander angeordneten Dioden befindlicher, elektrodenfreier Mittelabschnitt M des Streifenwellenleiters W1, bestehend aus dem mittleren Abschnitt R3 der Rippe R und dem mittleren Abschnitt Sch3 der Schicht Sch, verbindet die Dioden LD1 und LD2, die damit in Reihe zueinander geschaltet sind.

Die beiden Dioden LD1 und LD2 könnten auch parallel geschaltet sein, ähnlich wie die Halbleiterverstärker nach ECOC 87, S. 88, Figur 1b, wobei aber die beiden lichtverstärkend wirkenden Schichten der Dioden nicht wie dort senkrecht, sondern parallel zueinander anzuordnen sind.

Die geometrischen Strukturdaten der Laserdiode LD1, beispielsweise die Breite D1 des linken Endabschnitts W11 des Streifenwellenleiters W1 ist so gewählt, daß sie einen Polarisationszustand, beispielsweise den des TE-Modes, bevorzugt verstärkt. Die geometrischen Strukturdaten, der anderen Diode LD2, beispielsweise die Breite D2 des rechten Endabschnitts W12 des Wellenleiters W1, sind so gewählt, daß sie den anderen Polarisationszustand, beispielsweise den TM-Mode, bevorzugt verstärkt.

In der Figur 3 ist qualitativ die Verstärkung der Anordnung nach Figur 1 und 2 über dem Verhältnis der an die Elektroden EL1 und EL2 angelegten Betriebsströme $I_1$ bzw. $I_2$ der Dioden LD1 und LD2 aufgetragen. Dem Diagramm nach Figur 3 ist zu entnehmen, daß bei Werten von $I_1/I_2$, die kleiner als ein bestimmter Wert a sind, die TM-Verstärkung gegenüber der TE-Verstärkung vorherrscht, während für Werte von $I_1/I_2$, die größer als a sind, die TE-Verstärkung gegenüber der TM-Verstärkung vorherrscht. Bei dem bestimmten Wert a, der in speziellen Fällen auch gleich 1 sein kann, ist die TE-Verstärkung gleich der TM-Verstärkung, d.h. es liegt isotrope Verstärkung vor.

Bei dem der Figur 3 zugrundegelegten Betrieb der Anordnung nach Figur 1 und 2 sind vorzugsweise die durch die Endfläche F11 und F12 des Substrats Su definierten äußeren brechenden Endflächen der Dioden LD1 und LD2 entspiegelt, beispielsweise durch Antireflexschichten AS1 und AS2, die auf die Endflächen F11 bzw. F12 aufgebracht sind.

Beim Betrieb der Anordnung nach Figur 1 und 2 als frequenzselektiver Fabry-Perot-Verstärker oder als polarisations-bistabiles Sendeelement sind die Endflächen F11 und F12 nicht entspiegelt, so daß sie reflektieren. Sie können sogar verspiegelt sein.

Beim Betrieb als polarisations-bistabiles Sendeelement wird beispielsweise das Verhältnis $I_1/I_2$ so eingestellt, daß die Laseremission auf einen der beiden Rolarisationszustände eingestellt ist. Auf den Betriebsstrom der Diode, die den anderen Polarisationszustand bevorzugt verstärkt, wird eine Modulation aufgeprägt, derart, daß die Anordnung nach Figur 1 und 2 zwischen den beiden Polarisationszuständen wechselt. Wird beispielsweise TE-polarisierte Laseremission durch Wahl von $I_1$ und $I_2$ eingestellt und die Modulation $\Delta I(t)$ auf $I_2$ aufgeprägt, wechselt die Emission der Anordnung nach Figur 1 und 2 zwischen dem TE-Mode und dem TM-Mode. Dieser Wechsel kann sehr schnell erfolgen, so daß eine schnelle Modulation von Laserdioden gegeben ist.

In der Figur 4 sind qualitativ die soeben geschilderten Verhältnisse für das angegebene Beispiel dargestellt. In dieser Figur sind die beiden voreingestellten Betriebsströme $I_1$ und $I_2$ sowie die dem Betriebsstrom $I_2$ aufgeprägte Modulation $\Delta I(t)$ über der Zeit t dargestellt und darüber ist ebenfalls über der Zeit t die von der Anordnung nach Figur 1 und 2 abgegebene Lichtleistung aufgetragen, die zwischen TE- und TM-Polarisation wechselt. Der zeitliche Verlauf der von der Anordnung emittierten Lichtleistung des TE-Modes ist durch die durchgezogene Kurve TE und die des TM-Modes durch die gestrichelte Kurve TM gegeben.

Hinter einem Polarisationsfilter, welches nur einen Polarisationszustand, beispielsweise nur TM-polarisiertes Licht durchläßt, kann das mit hohem Modulationsgrad modulierte TM-polarisierte Licht ohne wesentlichen Gleichlichtpegel ausgekoppelt werden.

## Ansprüche

1. Halbleiterlaseranordnung, bestehend aus zwei hintereinander oder parallel zueinander geschalteten Halbleiterlasern, von denen einer vorherrschend Wellen eines bestimmten Polarisationszustandes (TE- oder TM-Polarisation) und die andere vorherrschend Wellen eines bestimmten anderen Polarisationszustandes (TM- bzw. TE-Mode) erzeugt oder verstärkt, wobei die von einem der beiden Halbleiterlaser verstärkten oder erzeugten optischen Wellen und die von dem anderen Halbleiterlaser verstärkten oder erzeugten optischen Wellen einander überlagerbar sind,
**dadurch gekennzeichnet,**
daß die beiden Halbleiterlaser quasi-indexgeführte Laserdioden (LD1, LD2) mit jeweils einer lichtverstärkend wirkenden Schicht (Sch1, Sch2) sind, die in einer gemeinsamen oder zueinander parallelen oder zueinander parallelen Schichtebenen (E) angeordnet sind.

2. Anordnung nach Anspruch 1, **dadurch gekennzeichnet,** daß die beiden quasi-indexgeführten Laserdioden (LD1, LD2) monolithisch integriert sind.

3. Anordnung nach Anspruch 1 oder 2, **dadurch gekennzeichnet,** daß brechende Ein- und Austrittsfläche für optische Wellen entspiegelt sind.

4. Anordnung nach Anspruch 1 oder 2, **dadurch gekennzeichnet,** daß brechende Ein- und Austrittsflächen für optische Wellen reflektierend sind.

5. Verfahren zum Betrieb einer Anordnung nach einem der vorhergehenden Ansprüche, insbesondere nach Anspruch 4, zur Realisierung einer in Bezug auf zwei verschiedene Polarisationszustände bistabilen Sendeanordnung,
**dadurch gekennzeichnet,**
daß das Verhältnis $I_1/I_2$ der Betriebsströme ($I_1$, $I_2$) der beiden Laserdioden (LD1, LD2) zwischen zwei Werten moduliert wird, die so ausgewählt sind, daß bei einem Wert in einer von der Anordnung erzeugten oder verstärkten optischen Welle einer der beiden Polarisationszustände und beim anderen Wert der andere Polarisationszustand vorherrscht.

FIG 1

FIG 2

FIG 3

Verstärkung

TE-Mode

TM-Mode

$I_1/I_2$

FIG 4

Lichtleistung

TM    TE

t

Strom

$I_2 + \Delta I(t)$

$I_1$

$I_2$

t